**Europäisches Patentamt**

**European Patent Office**

**Office européen des brevets**

(11) Veröffentlichungsnummer: **0 124 128**
**A2**

## (12) EUROPÄISCHE PATENTANMELDUNG

(21) Anmeldenummer: **84104875.4**

(22) Anmeldetag: **01.05.84**

(51) Int. Cl.³: **H 01 L 35/26**

(30) Priorität: **02.05.83 DE 3315960**

(43) Veröffentlichungstag der Anmeldung: **07.11.84**
**Patentblatt 84/45**

(84) Benannte Vertragsstaaten: **AT CH FR GB IT LI SE**

(71) Anmelder: **Bschorr, Oskar, Dr. rer. nat.,**
**Keplerstrasse 11, D-8000 München 80 (DE)**

(72) Erfinder: **Bschorr, Oskar, Dr., Keplerstrasse 11,**
**D-8000 München 80 (DE)**
Erfinder: **Rotter, Christoph, Dipl. Ing., Togostrasse 24,**
**D-8000 München 82 (DE)**

(54) **Erzeugung von Spannungsdifferenzen.**

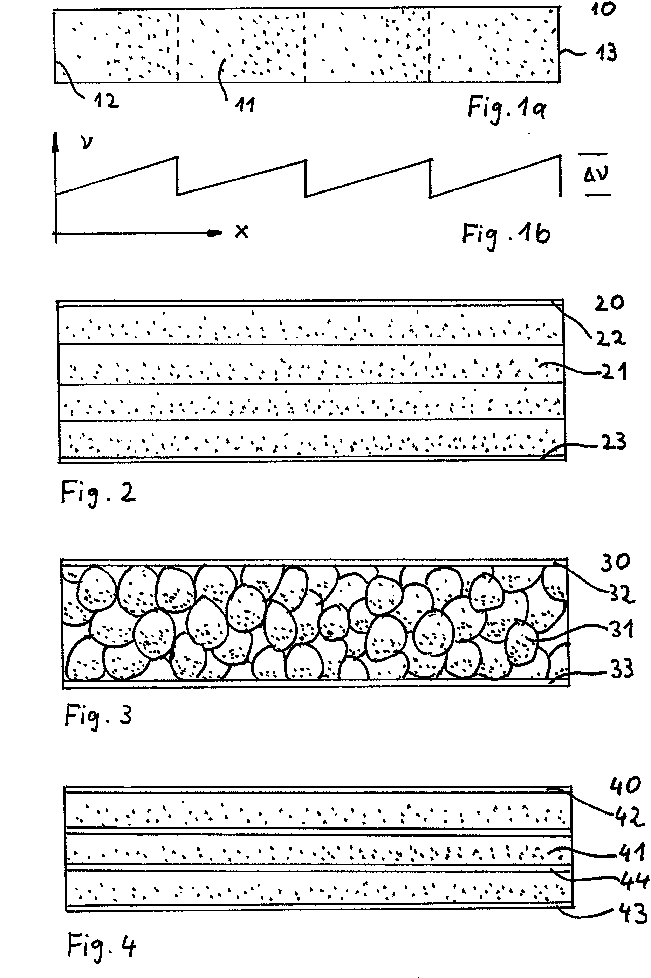

㊿ Es ist die Aufgabe gestellt, elektrische Spannungen zu erzeugen. Dazu wird in einem Stromleiter ein sägezahnförmiger Dotierungsverlauf der elektrischen Eigenschaften, insbesondere der mittleren, freien Weglänge, eingestellt. Dabei weist die eine Zahnflanke einen kontinuierlichen, die andere einen abrupten, innerhalb einer freien Weglänge verlaufenden Gradienten auf. Über beiden Teilen stellen sich unterschiedliche Spannungsdifferenzen ein. Durch Schichtung lässt sich die freie, elektromotorische Kraft aufsummieren (Fig. 1).

## Erzeugung von Spannungsdifferenzen

Die Erfindung bezieht sich auf die Erzeugung von Spannungsdifferenzen und elektromotorischen Kräften. Dazu wird die elektrische Spannung, die sich in einem inhomogenen Stromleiter bzw. an der Kontaktstelle zweier verschiedener Leiter einstellt, ausgenützt.

Zunächst soll die zum Verständnis und zur Dimensionierung notwendige Theorie zusammengestellt werden. Die elektrischen Eigenschaften eines Stromleiters sollen durch ein Elektronengas beschrieben werden. Bekanntlich können die Verhältnisse in Halbleitern durch ein Drude-Gas approximiert werden, während bei den hohen Elektronendichten Entartung vorliegt und ein Fermi-Gas zugrunde gelegt werden kann. Das Elektronengas soll durch die Dichte $n_o$ der freien, an der Stromleitung beteiligten Elektronen charakterisiert sein. Im weiteren sei n die Dichte der thermischen Elektronen pro Volumeneinheit. (Beim Drude-Gas ist $n = n_o$, nicht aber beim Fermi-Gas.) Die mittlere Geschwindigkeit der thermischen Elektronen sei c und deren mittlere freie Weglänge zwischen 2 Kollisionen sei l. Eine weitere Kenngröße ist das elektrochemische Potential µ. Die Masse eines Elektrons soll mit m und seine Ladung mit e bezeichnet werden. - Vollkommen analog und übertragbar sind die Verhältnisse bei anderen Leitertypen, z.B. Ionenleitern und Löcherleitern. Im besonderen kann wieder ein Ionen- bzw. Löcher-Gas unterstellt werden. Auch wenn alle 3 genannten Stromleiter unter die Sammelbezeichnung Ladungsträger-Gas fallen, soll die Beschreibung am Beispiel des Elektronengases fortgeführt werden.

Zunächst sei unterstellt, daß das Elektronengas homogen und isotrop ist und sich im stationären Gleichgewichtszustand befindet. Darauf soll die von Kirchhoff für die thermische Strahlung aufgestellte Emissions-/Absorptionsbilanz übertragen werden. Ursprünglich bezieht sich diese Bilanz auf die lokale Energieerhaltung. Sie besagt, daß im stationären Gleichgewicht pro Volumeneinheit genau soviel Lichtenergie emittiert wie absorbiert wird. Die Wechselwirkung - der Zusammenstoß - eines Photons mit einem Atom wird dabei als Absorptions-/Emissionsprozeß angenommen. Die Photonenenergie vor dem Stoß wird dabei als absorbiert und die nach dem Stoß als emittiert aufgefaßt. Eine solche Überlegung kann auf alle Größen, für die Erhaltungssätze bestehen, ausgedehnt und soll für die vorliegende Aufgabenstellung auf die lokale Ladungserhaltung angewendet werden. Analog wird beim Zusammenstoß eines Elektrons mit einer Störstelle im Leiter das Ende der alten Bahn als Absorption und der Beginn der neuen Elektronenbahn als Emission von elektrischer Ladung deklariert.

Wie sich bei Kirchhoff eine lokale (Energie)-Emission definieren läßt, soll
hier eine Ladungsemission $\nu$ eingeführt werden. Sie beschreibt die pro Volumen-, Zeit- und Raumwinkeleinheit emittierte elektrische Ladung und beträgt
mit den eingeführten Kennwerten bei Homogenität und Isotropie

$$\nu = enc/4\pi l$$

Diese Beziehung soll auf ein einachsig inhomogenes Elektronengas erweitert
werden. Die Inhomogenität soll durch den Gradienten $\nu'_{Dot}$ der Ladungsemission
ausgedrückt sein. Der Index "Dot" dient hierbei als Sammelbegriff für die
verschiedenen Dotierungsverfahren wie Diffusion, Implantation, Aufdampfen,
Elektrolyse usw., wie sie besonders in der Halbleiterfertigung bekannt sind.
Der Gradient $\nu'_{Dot}$ läßt sich auf seine Komponenten n, c und 1 zurückführen.
Es ist

$$\frac{\nu'_{Dot}}{\nu} = \frac{n'_{Dot}}{n} + \frac{c'_{Dot}}{c} - \frac{l'_{Dot}}{l}$$

$n'_{Dot}$, $c'_{Dot}$ und $l'_{Dot}$ sind die Gradienten der Elektronendichte n, der thermischen Elektronengeschwindigkeit c und der freien Weglänge l. Während der homogene Leiter im stationären Zustand spannungs- und stromfrei ist, kommt es bei
Inhomogenität zu Ausgleichsvorgängen. Unter der Voraussetzung, daß sich die
Ladungsemission $\nu$ innerhalb einer freien Weglänge nur wenig ändert, d.h.
$|\nu'_{Dot}|l \ll |\nu|$, kann lokal von einem quasihomogenen und quasiisotropen
Elektronengas ausgegangen werden und man erhält einen Anfangsstrom j.

$$j_0 = \pi l^2 \nu'_{Dot} = \frac{1}{4} encl \frac{\nu'_{Dot}}{\nu}$$

Der Strom hält solange an, bis sich im Gleichgewicht im allgemeinen Fall ein
Temperaturgradient $T'$ und ein Spannungsgradient $U'$ ausbildet, bei dem der
Stromfluß verschwindet. Dieser Zustand ist durch die Balance-Gleichung bestimmt ($\sigma$ = elektrische Leitfähigkeit).

$$j = 0 = \frac{1}{4} encl \left( \frac{\nu'_{Dot}}{\nu} + \frac{d\nu}{\nu dT}T' + \frac{d\nu}{\nu dU}U' \right) - \sigma U'$$

Mit einer analogen Bedingung - daß auch der Wärmestrom Null ist - bestehen 2 Gleichungen für die beiden Unbekannten T' und U'. Der Einfachheit halber soll hier der Temperatureinfluß und auch der Diffusions- gegen den Driftstrom vernachlässigt werden. Mit diesen Vereinfachungen erhält man den stationären Spannungsgradienten U' in einem inhomogenen Leiter.

$$U' \approx \frac{enc\ell}{4\sigma} \frac{\nu'_{Dot}}{\nu}$$

Insbesondere ist die Spannungsdifferenz $\Delta U_A$, wenn sich die Ladungsemission innerhalb einer Leiterstrecke $\Delta x$ um den Betrag $\Delta\nu$ verändert.

$$\Delta U_A \approx \frac{enc\ell}{4\sigma} \frac{\Delta\nu}{\nu} = \frac{enc\ell}{4\sigma}\left(\frac{\Delta n}{n} + \frac{\Delta c}{c} - \frac{\Delta\ell}{\ell}\right)$$

Diese Beziehung gilt voraussetzungsgemäß bei einem schwachen Dotierungsgradienten $\nu'_{Dot}$ innerhalb der Strecke $\Delta x$. Demgegenüber ergibt sich eine andere Spannungsdifferenz, wenn sich die Ladungsemission $\nu$ sprunghaft ändert, wenn die Änderung $\Delta\nu$ innerhalb einer Strecke erfolgt, die klein ist gegen die freie Weglänge 1. Die Bedingung hierfür lautet $|\nu'_{Dot}|\ell \ll |\nu|$ . Die dabei auftretende Spannungsdifferenz soll mit $\Delta U_B$ bezeichnet werden und hängt insbesondere vom elektrochemischen Potential an der Sprungstelle ab. Sind beide Stoffe an der Sprungstelle chemisch gleich und unterscheiden sich nur durch die freie Weglänge, so ist für diesen Sonderfall $\Delta U_B = 0$. An einer Leiterschicht mit einem asymetrischen, sägezahnförmigen Inhomogenitätsverlauf, wobei an der einen Zahnflanke die Ladungsemission langsam um den Betrag $\Delta\nu$ ansteigt und an der anderen um denselben Betrag abrupt abfällt, liegt so eine freie, resultierende elektromotorische Kraft $\Delta U$ an

$$\Delta U = \Delta U_A + \Delta U_B$$

Durch Hintereinanderschalten von n derartigen Schichten ergibt sich die n-fache Nutzspannung.

Aufgabe der Erfindung ist es, diesen elektromotorischen Effekt anzuwenden und zu optimieren, Verfahren zur Herstellung elektromotorischer Elemente anzugeben und vorteilhafte Ausführungsformen zu beschreiben. Dies soll anhand von 4 Beispielen erfolgen:

Fig. 1 : Draht- oder streifenförmig mehrstufiges elektromotorisches Element.

Fig. 2 : Mehrstufiges elektromotorisches Element in
Schichtbauweise.

Fig. 3: Elektromotorisches Element in gradientendotierter
Pulverschichtung.

Fig. 4: Mehrstufiges, elektromotorisches Element mit Zusatzschichten.

In Fig. 1 a ist ein elektromotorisches Element 10, bestehend aus einzelnen
Abschnitten 11 dargestellt. Das Element 10 besteht aus einem durchgehenden,
stromleitenden Draht oder Band, beispielsweise aus Kupfer. Die einzelnen Abschnitte 11 weisen eine Gradientendotierung auf. Der Verlauf der Ladungsemission $\nu$ ist in Fig. 1b über die Drahtlänge (Bandlänge) x dargestellt und
ist durch einen asymetrischen Sägezahnverlauf mit der Zahnhöhe $\Delta\nu$ gekennzeichnet. Die eine Sägezahnflanke hat einen geringen Gradienten $\nu'_{Dot}$ mit
$|\nu'_{Dot}| \ell << |\nu|$ während die andere einen möglichst abrupten mit $|\nu'_{Dot}| \ell >> |\nu|$
hat. Der Abfall sollte möglichst auf einer Strecke, kleiner als die freie Weglänge 1, erfolgen. Eine solche Verteilung kann analog den in der Halbleitertechnik bekannten Dotierungsverfahren hergestellt werden. Z.B. kann durch
Ionenimplantation die Fehlstellendichte und damit die freie Weglänge 1 um den
Betrag $\Delta\nu/\nu = -\Delta\ell/\ell$ variiert werden. Bei sonst homogenen Leitereigenschaften ($\Delta$n, $\Delta$ c = 0) ergibt sich so pro Abschnitt 11 eine freie Spannungsdifferenz $\Delta$U

$$\Delta U = \Delta U_A + \Delta U_B = \frac{enc}{4\sigma} \Delta\ell$$

die sich entsprechend der Zahl der Abschnitte 11 erhöht und an den Elektroden
12 und 13 abgenommen werden kann. Die verbrauchte Wärme wird dabei der Umgebung
entnommen. Das elektromotorische Element 10, gleichzeitig als Leiter in einem
Elektromotor verwendet, vermag so die Joule'sche Verlustwärme aufzunehmen, so
daß höhere Motorlasten möglich sind. Bei Kurzschluß der Elektroden 12 und 13
ergibt sich ein Ringstrom, der beispielsweise zur Erzeugung eines Magnetfeldes
genutzt werden kann.

Das mehrstufige elektromotorische Element 20 ist in Fig. 2 im Querschnitt dargestellt. Es besteht aus mehreren Schichten 21, die analog zu Fig. 1 je einen asymetrischen, sägezahnförmigen Verlauf der Ladungsemission $\nu$ aufweisen. Ein solcher Aufbau läßt sich durch gesteuertes Aufdampfen zweier oder mehrerer Komponenten oder durch gesteuerte Elektrolyse herstellen. Außerdem ist es möglich, einzelne Scheiben einseitig einer Diffusion auszusetzen und diese in der dargestellten Weise zu schichten. An den Kontaktstellen besteht so eine sprunghafte Änderung der Dotierung, während im Innern der Schichten 21 ein schwacher Dotierungsgradient $\nu'_{Dot}$ herrscht, entsprechend dem geforderten asymetrischen Verlauf. Die Mindestdicke einer Schicht beträgt einige freie Weglängen l. Die maximale Dicke ist nicht begrenzt und kann entsprechend anderen Randbedingungen wie Herstellbarkeit, Wärmeleitung, Spannungsbedarf, gewählt werden. Pro Schicht beträgt die freie elektromotorische Kraft $\Delta\nu = \Delta\nu_A + \Delta\nu_B$ und ist bei Hintereinanderschaltung von n-Schichten n-mal größer. Die verbrauchte Wärme wird durch Wärmeleitung von außen zugeführt. Aus diesem Grund ist es vorteilhaft, Schichtmaterialien mit hoher Wärmeleitfähigkeit, z.B. Metalle, zu verwenden. Auch ist es möglich, das elektromotorische Element in Rohrform herzustellen, wobei im Rohrinnern der Wärmeträger, z.B. Wasser, zugeführt wird.

Das elektromotorische Element 30 nach Fig. 3 unterscheidet sich im Herstellungsverfahren von den vorangegangenen Ausführungsformen. Es besteht aus pulverförmigem, stromleitendem Material. Das einzelne Pulverkorn 31 hat eine Mindestabmessung von mehreren freien Weglängen l, weist wieder einen Gradienten $\nu'_{Dot}$ der Ladungsemission auf und ist ausgerichtet. Eine solche Anordnung läßt sich durch Pulverbeschichtung und gleichzeitiger Ionenimplantation erreichen. Die Einzelspannungen $\Delta\nu$ summieren sich wieder auf und können an den Elektroden 32 und 33, die hier gleichzeitig als Schutzschicht wirken, abgenommen werden.

Das Ausführungsbeispiel nach Fig. 4 ist weitgehend analog zu Fig. 2. Das elektromotorische Element 40 setzt sich aus einzelnen Schichten 41 zusammen, die je einen asymetrischen, sägezahnförmigen Verlauf der Inhomogenität aufweisen. Zwischen den Schichten 41 befindet sich eine Zusatzschicht 44 aus einem Material, dessen elektrochemisches Potential verschieden von dem der Schicht 41 ist. Damit läßt sich einmal die nutzbare Schichtspannung vergrößern und bei kleinen Dicken der Zusatzschicht der Tunneleffekt anwenden. Im weiteren können an den Zusatzschichten 44 Steuerspannung angelegt und so Spannungs- und Stromverlauf des elektromotorischen Elementes 40 variiert werden. Die Elementspannung wird an den Elektroden 42 und 43 abgenommen.

Bei der Speisung von elektrischen Schaltkreisen ist es zweckmäßig, die elektromotorischen Elemente mit in den Kreis direkt zu integrieren oder so anzulegen,

daß der Wärmeweg vom Stromverbraucher zum Element möglichst kurz und entsprechend der Wärmewiderstand gering ist. Im weiteren eignen sich Wärmerohre mit ihrem geringen Wärmewiderstand gut zur Zuführung der im elektromotorischen Element verbrauchten Wärmeenergie. Bei großen elektrischen Leistungen ist es zweckmäßig, die Zahl der Schichten zu begrenzen und dazwischen liegende Wärmekanäle vorzusehen. Auf der anderen Seite kann ein elektromotorisches Element auch zur Kühlung verwendet werden.

## Schutzansprüche

1. Erzeugung von elektromotorischen Spannungsdifferenzen, dadurch gekennzeichnet, daß ein stromleitender Körper aus einer oder mehreren Schichten besteht, die eine Mindestdicke von mehreren freien Weglängen der Ladungsträger, z.B. Elektronen, haben, die in Schichtnormale einen asymmetrischen sägezahnförmigen Inhomogenitätsverlauf der Ladungsemission $\nu$ aufweisen, wobei der Gradient $\nu'_{Dot}$ der Ladungsemission aus den Gradienten der chemischen Zusammensetzung, der Dotierung und/oder der freien Weglänge $l$ der Ladungsträger gebildet ist und an der einen Zahnflanke einen schwachen Gradient $\nu'_{Dot}$ mit der Bedingung $|\nu'_{Dot}|\, l \ll |\nu|$ und an der anderen ein möglichst steiler Gradient mit $|\nu'_{Dot}|\, l \gg |\nu|$ besteht und die sich einstellende Spannung an den stirnseitigen Elektroden abgenommen wird.

2. Erzeugung von elektromotorischen Spannungsdifferenzen nach Anspruch 1 dadurch gekennzeichnet, daß der in Schichtnormalen herrschende Inhomogenitätsverlauf durch Ionenimplantation, gesteuerte Aufdampfung, chemische und elektrolytische Abscheidung zweier oder mehrerer Stoffe und/oder nach den anderen aus der Halbleitertechnik bekannten Dotierungsverfahren hergestellt wird.

3. Erzeugung von elektromotorischen Spannungsdifferenzen nach Anspruch 1 dadurch gekennzeichnet, daß mehrere Scheiben durch einseitige Diffusion und/oder Ionenimplantation von Fremdatomen, Störstellen, Donatoren und/oder Akzeptoren einen Inhomogenitätsgradienten $\nu'_{Dot}$ mit der Bedingung $|\nu'_{Dot}|\, l \ll |\nu|$ erhalten und in stromleitenden Kontakt gleichgerichtet übereinander geschichtet sind.

4. Erzeugung von elektromotorischen Spannungsdifferenzen nach den Ansprüchen 1 und 2 dadurch gekennzeichnet, daß Pulverkörner aus einem stromleitenden Material einen Dotierungsgradienten aufweisen und gleichsinnig ausgerichtet in stromleitenden Kontakt geschichtet sind.

5. Erzeugung von elektromotorischen Spannungsdifferenzen nach den Ansprüchen 1 bis 3 dadurch gekennzeichnet, daß zwischen den Schichten mit asymmetrischem sägezahnförmigem Inhomogenitätsverlauf Zusatzschichten mit unterschiedlichem elektrochemischem Potential eingebracht sind.

0124128

6.  Elektromotorisches Element nach den Ansprüchen 1 bis 5 dadurch gekennzeichnet, daß die beiden Elektroden zur Aufrechterhaltung eines
    Ringstroms kurzgeschlossen sind.

7.  Elektromotorisches Element nach den Ansprüchen 1 bis 5 dadurch gekennzeichnet, daß dieses gleichzeitig als Leiter in einem elektrodynamischen Momenten- oder Kraftgeber ausgebildet ist, um die Verlustwärme
    aufzunehmen.

8.  Elektromotorisches Element nach den Ansprüchen 1 bis 5 dadurch gekennzeichnet, daß dieses mit in den zu versorgenden elektrischen Schaltkreis
    integriert ist oder möglichst nahe an den leistungsverbrauchenden Bauteilen angeordnet ist.

9.  Elektromotorisches Element nach den Ansprüchen 1 bis 5 dadurch gekennzeichnet, daß die verbrauchte Wärme oder Umgebung durch Wärmeleitung,
    mittels Wärmerohr oder mittels eines flüssigen, dampf- oder gasförmigen Wärmeträgers zugeführt wird.

10. Elektromotorisches Element nach den Ansprüchen 1 bis 5 dadurch gekennzeichnet, daß die verbrauchte Wärme dem zu kühlenden Objekt entnommen
    wird.

0124128

10

13

12                    11                              Fig. 1a

$\nu$

$\overline{\Delta \nu}$

x

Fig. 1b

20
22
21

23

Fig. 2

30
32
31
33

Fig. 3

40
42
41
44
43

Fig. 4